# EUROPÄISCHE PATENTSCHRIFT

(11) **EP 3 631 966 B1**
(45) Veröffentlichungstag und Bekanntmachung des Hinweises auf die Patenterteilung: **09.11.2022**
(21) Anmeldenummer: 18714999.2
(22) Anmeldetag: 22.03.2018
(51) Int. Cl.: H02M 7/00, B60K 11/02, H01L 23/36, H02K 9/19, H05K 7/20, H02K 11/33, B60K 1/00

(54) **KRAFTFAHRZEUG UND STROMRICHTEREINRICHTUNG FÜR EIN KRAFTFAHRZEUG**
MOTOR VEHICLE AND INVERTER DEVICE FOR A MOTOR VEHICLE
VÉHICULE AUTOMOBILE ET DISPOSITIF ONDULEUR POUR UN VÉHICULE AUTOMOBILE

(30) Priorität: 22.05.2017 DE 102017208632
(43) Veröffentlichungstag der Anmeldung: 08.04.2020
(73) Patentinhaber: Audi AG, 85045 Ingolstadt (DE)
(72) Erfinder: SÖHNLE, Benjamin, 85051 Ingolstadt (DE)
(86) Internationale Anmeldenummer: PCT/EP2018/057257
(87) Internationale Veröffentlichungsnummer: WO 2018/215117

(56) Entgegenhaltungen:
- WO-A1-2013/140704
- DE-A1-102011 053 727
- DE-A1-102014 220 835
- DE-A1-102015 214 770
- JP-A- 2016 032 330
- JP-A- 2016 174 501
- US-A1- 2001 017 039
- US-A1- 2010 097 765
- US-A1- 2016 039 277

## Beschreibung

Die Erfindung betrifft ein Kraftfahrzeug, umfassend eine elektrische Maschine zum Antrieb des Kraftfahrzeugs und eine eine Kühlvorrichtung aufweisende Stromrichtereinrichtung zur Bereitstellung eines Wechselstroms für die elektrische Maschine.

Bei teilweise oder vollständig elektrisch angetriebenen Kraftfahrzeugen wird eine von einer Hochvoltbatterie bereitgestellte Gleichspannung typischerweise mittels einer Stromrichtereinrichtung in einen ein- oder mehrphasigen Wechselstrom zum Antrieb einer elektrischen Maschine gewandelt. Besonderes Augenmerk gilt hier der Kühlung der sich während ihres Betriebs erwärmenden Stromrichtereinrichtung mittels einer Kühlvorrichtung.

Aus DE 10 2009 058 270 A1 ist ein Wechselrichter für elektrische Traktionssysteme in der Fahrzeugtechnik bekannt, umfassend auf einer Kühlplatte angeordneten Leistungsmodule, welche mit einer elektronischen Maschine verbunden sind, und einen sich unterhalb der Leistungsmodule befindenden Wasserkühler.

Bei einer derartigen Anordnung ist der Wasserkühler exklusiv zur Kühlung der Stromrichtereinrichtung vorgesehen, was erheblichen Bauraum in Anspruch nimmt. Des Weiteren befinden sich leckageanfällige Dichtungen innerhalb des Wechselrichters.

DE 10 2010 029 374 A1 offenbart ferner einer Leistungselektronikanordnung mit einem Leistungselektronik-Gehäuse und darin aufgenommenen Elektronikbauteilen sowie einer Anschlussvorrichtung mit auf dem Leistungselektronik-Gehäuse angeordneten elektrischen Anschlüssen, die zum Anschluss mehrerer Hochvoltkabel an die Elektronikbauteile oder von Teilen hiervon vorgesehen sind.

DE 10 2014 002 522 A1 offenbart eine Batterie für ein Fahrzeug, umfassend eine Mehrzahl von miteinander verschalteten Batteriezellen und eine Ableiterkühlung zur Kühlung der Batteriezellen, wobei die Ableiterkühlung eine Kühlplatte aufweist, die wärmeleitend mit den Polen der Batteriezellen verbunden ist und die im Bereich der Pole der Batteriezellen Durchgangsöffnungen aufweist, in oder durch die die Pole hinein- bzw. hindurchragen. Die Batteriezellen sind über die zugehörigen Pole jeweils mittels eines thermisch leitfähigen und elektrisch isolierenden Keramikelements an der Kühlplatte thermisch kontaktiert.

Weiterhin zeigen JP2016174501 und JP2016032330 Traktionsantriebe mit integrierten Kühlflüssigkeitsschnittstellen zwischen der elektrischen Maschine und dem aufgesetzten Umrichter.

Der Erfindung liegt die Aufgabe zugrunde, eine Stromrichtereinrichtung in einem Kraftfahrzeug bauraumsparend und robust betreibbar auszugestalten.

Die Erfindung ist durch die Merkmale des Anspruchs 1 festgelegt. Die abhängigen Ansprüche definieren vorteilhafte Ausgestaltungen der Erfindung Zur Lösung dieser Aufgabe ist erfindungsgemäß bei einem Kraftfahrzeug der eingangs genannten Art vorgesehen, dass die Kühlvorrichtung wenigstens einen Kühlflüssigkeitsanschluss aufweist, welcher zur Ausbildung eines gemeinsamen Kühlkreislaufs mit einer Kühlflüssigkeitsschnittstelle der elektrischen Maschine flüssigkeitsleitend verbunden ist.

Die Erfindung beruht auf der Überlegung, die Kühlvorrichtung zur Kühlung der Stromrichtereinrichtung in den Kühlkreislauf der elektrischen Maschine, welcher beispielsweise zur Statorkühlung und/oder Rotorkühlung dient, einzubinden. Die Kühlvorrichtung kann so vorteilhafterweise vorhandene Kühlkomponenten der elektrischen Maschine mitnutzen, um Bauraum der Stromrichtereinrichtung einzusparen. Gleichzeitig kann so die Anzahl an abzudichtenden flüssigkeitsleitenden Verbindungsstellen reduziert und ein robusterer Betrieb der Stromrichtereinrichtung und des Kraftfahrzeugs insgesamt erzielt werden.

Die Stromrichtereinrichtung ist an einem Maschinengehäuse der elektrischen Maschine angeordnet, wobei die Stromrichtereinrichtung und das Maschinengehäuse einen Aufnahmebereich begrenzen, in welchem der Kühlflüssigkeitsanschluss und die Kühlflüssigkeitsschnittstelle angeordnet sind. Der Aufnahmebereich ist von einem muldenartigen Abschnitt des Maschinengehäuses begrenzt. Der Abschnitt ist zweckmäßigerweise an einer Außenseite des Maschinengehäuses vorgesehen. Typischerweise weist er Wände auf, die sich in Radialrichtung bezüglich der Rotationsachse der elektrischen Maschine erstrecken. Die Stromrichtereinrichtung ist dann auf die freien Enden der Wände aufgesetzt und begrenzt so den Aufnahmebereich gemeinsam mit den Wänden des Maschinengehäuses.

Die Stromrichtereinrichtung weist eine Grundplatte zur Anordnung von Komponenten der Stromrichtereinrichtung auf. Bevorzugt werden auch Stromschienen, die Komponenten miteinander verbinden, entlang der Grundplatte geführt und können so gekühlt werden.

Dabei kann die Kühlvorrichtung durch mehrere innerhalb der Grundplatte vorgesehene Kühlkanäle ausgebildet sein. Die Grundplatte ist mithin durch die Kühlflüssigkeit durchströmbar. Die Grundplatte kann demnach als aktiver Kühlkörper verwendet werden, um von den Komponenten der Stromrichtereinrichtung erzeugte Wärme effektiv an den gemeinsamen Kühlkreislauf abzuführen.

In einer alternativen Ausgestaltung kann die Kühlvorrichtung an der Grundplatte angeordnet sein. Die Grundplatte ist in diesem Fall im Wesentlichen als Trägerelement für die Komponenten und die Kühlvorrichtung ausgebildet und dient lediglich passiv zur Weiterleitung von Wärme an die an ihr angeordnete Kühlvorrichtung. Besonders bevorzugt ist die Kühlvorrichtung in die Grundplatte eingelassen. Das heißt, dass die Grundplatte eine Ausnehmung aufweist, innerhalb welcher sich zumindest Teile der Kühlvorrichtung befinden. So ist eine besonders bauraumsparende Anordnung der Kühlvorrichtung möglich.

Bei einigen Ausführungsformen des erfindungsgemäßen Kraftfahrzeugs ist es zweckmäßig, wenn der Kühlflüssigkeitsanschluss an der der elektrischen Maschine zugewandten Seite oder an wenigstens einer Randseite der Grundplatte angeordnet ist. Als Randseiten sind hierbei die Seiten der Grundplatte aufzufassen, welche die der elektrischen Maschine zugewandte Seite und die der elektrischen Maschine abgewandte Seite der Grundplatte verbinden.

Als Komponenten der Stromrichtereinrichtung können eine leistungselektronische Stromrichtereinheit und/oder ein Zwischenkreiskondensator und/oder eine Steuereinrichtung und/oder ein Gleichspannungsanschluss zur Verbindung der Stromrichtereinrichtung mit ein Niedervoltbordnetz des Kraftfahrzeugs vorgesehen sein. Diese Komponenten sind bevorzugt an der der elektrischen Maschine abgewandten Seite der Grundplatte angeordnet.

Besonders bevorzugt ist die Stromrichtereinheit auf der an der Grundplatte angeordneten Kühlvorrichtung angeordnet. Da die Stromrichtereinheit typischerweise den größten Beitrag zur Wärmeerzeugung der Stromrichtereinrichtung beiträgt, wird eine unmittelbare thermische Kopplung mit der Kühlvorrichtung bevorzugt. Auch wenn die Grundplatte selbst die Kühlvorrichtung ausbildet, ist es zweckmäßig eine möglichst hohe Wärmeübertragung von der Stromrichtereinheit an die Grundplatte zu ermöglichen, beispielsweise durch eine möglichst große Kontaktfläche. Zweckmäßig ist auch eine unmittelbare Anordnung des Zwischenkreiskondensators an der Grundplatte bzw. der Kühlvorrichtung, da auch dieser erheblich zur Wärmeentwicklung der Stromrichtereinrichtung beiträgt.

Als Komponenten der Stromrichtereinrichtung können ferner eine elektromagnetische Filtereinheit und/oder ein Wechselspannungsanschluss zur elektrischen Verbindung der Stromrichtereinrichtung mit der elektrischen Maschine und/oder ein Gleichspannungsanschluss zur elektrischen Verbindung der Stromrichtereinrichtung mit einem Hochvoltbordnetz und/oder ein Gleichspannungsanschluss zur elektrischen Verbindung der elektrischen Maschine mit einem Niedervoltbordnetz des Kraftfahrzeugs über die Stromrichtereinrichtung vorgesehen sein. Diese Komponenten sind bevorzugt auf der der elektrischen Maschine zugewandten Seite der Grundplatte angeordnet.

Es wird ferner vorgesehen, dass ein Gehäuseteil der Stromrichtereinrichtung die an der der elektrischen Maschine zugewandten Seite angeordneten Komponenten einhaust. Dieser Gehäuseteil kann auch als erster Gehäuseteil bezeichnet werden.

Gemäß einer Ausgestaltungsvariante kann der Kühlflüssigkeitsanschluss den Gehäuseteil durchdringen. In diesem Fall liegt die Kühlvorrichtung teilweise innerhalb des Gehäuseteils und erstreckt sich derart außerhalb des Gehäuseteils, dass zumindest der Kühlflüssigkeitsanschluss außerhalb des Gehäuseteils liegt.

Eine alternative Ausgestaltungsvariante sieht vor, dass der Kühlflüssigkeitsanschluss außerhalb des Gehäuseteils an der Grundplatte angeordnet ist. In diesem Fall haust der Gehäuseteil die Grundplatte nur abschnittsweise ein, es liegt mithin wenigstens ein Abschnitt der Grundplatte außerhalb des Gehäuseteils. Der Kühlflüssigkeitsanschluss ist dann besonders einfach von außen zugänglich. Besonders bevorzugt wird, dass der außerhalb des Gehäuseteils vorgesehene Kühlflüssigkeitsanschluss an der der elektrischen Maschine zugewandten Seite der Grundplatte oder an der oder einer Randseite der Grundplatte angeordnet ist.

Außerdem ist es zweckmäßig, wenn ein Gehäuseteil der Stromrichtereinrichtung die auf der der elektrischen Maschine abgewandten Seite angeordneten Komponenten einhaust. Der Gehäuseteil kann auch als zweiter Gehäuseteil bezeichnet werden. Bevorzugt haust der Gehäuseteil die der elektrischen Maschine abgewandte Seite der Grundplatte vollständig ein. Der Gehäuseteil kann durch Befestigungselemente an dem Maschinengehäuse, insbesondere am muldenartigen Abschnitt und/oder an den Wänden des Maschinengehäuses, befestigt oder befestigbar sein.

Die Gehäuseteile sind bevorzugt separat ausgebildet oder Teile eines zusammenhängenden Gehäuses.

Weitere Vorteile und Einzelheiten der Erfindung ergeben sich aus den im Folgenden beschriebenen Ausführungsbeispielen sowie anhand der Zeichnungen. Diese sind schematische Darstellungen und zeigen:
- Fig. 1: eine Detaildarstellung einer elektrischen Maschine für ein Kraftfahrzeug;
- Fig. 2: eine Schnittdarstellung eines ersten Ausführungsbeispiels einer erfindungsgemäßen Stromrichtereinrichtung für das Kraftfahrzeug;
- Fig. 3: eine Explosionsdarstellung eines weiteren Ausführungsbeispiels einer erfindungsgemäßen Stromrichtereinrichtung für das Kraftfahrzeug;
- Fig. 4: eine perspektivische Darstellung der in Fig. 3 gezeigten Stromrichtereinrichtung;
- Fig. 5: eine geschnittene Prinzipdarstellung eines weiteren Ausführungsbeispiels einer erfindungsgemäßen Stromrichtereinrichtung für das Kraftfahrzeug; und
- Fig. 6: eine Prinzipskizze eines Ausführungsbeispiels eines erfindungsgemäßen Kraftfahrzeugs.

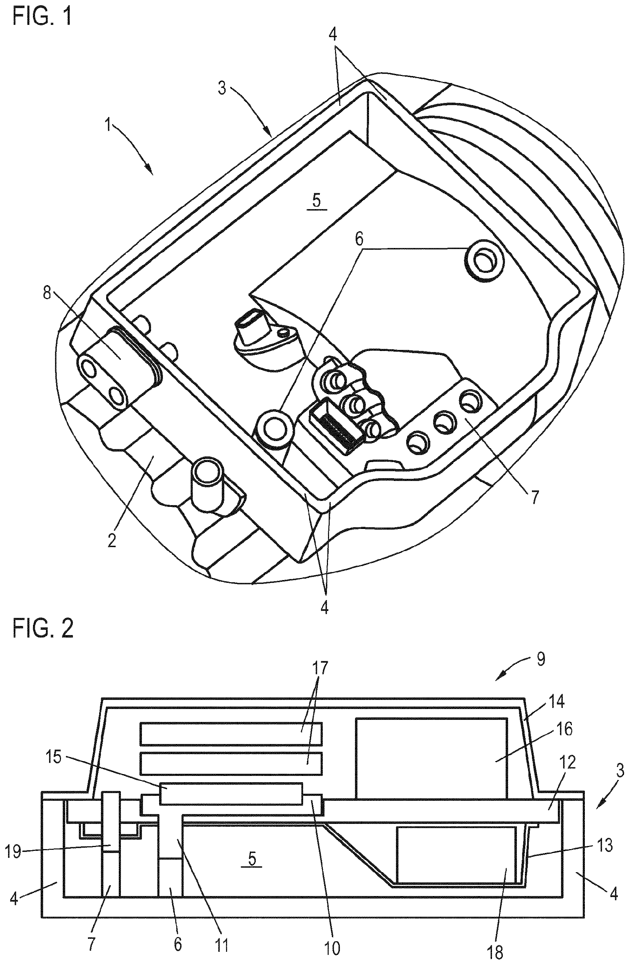

Fig. 1 zeigt eine Detaildarstellung einer elektrischen Maschine 1, wobei abschnittsweise ein Maschinengehäuse 2 sichtbar ist.

Das Maschinengehäuse 2 weist einen muldenartigen Abschnitt 3 mit mehreren Wänden 4 auf, welche einen Aufnahmebereich 5 begrenzen. Innerhalb des Aufnahmebereichs 5 ist eine Kühlflüssigkeitsschnittstelle 6 zur Ein- und Ableitung einer Kühlflüssigkeit zur Kühlung eines Stators und/oder eines Rotors der elektrischen Maschine 1 vorgesehen. Daneben sind innerhalb des Aufnahmebereichs 5 eine Anschlussvorrichtung 7 für eine Versorgung der elektrischen Maschine 1 mit einer dreiphasigen Wechselspannung und mit einer von einer Niedervoltbatterie bereitgestellten Gleichspannung von beispielsweise 12 Volt vorgesehen. Ferner ist in eine Wand 4 ein Gleichspannungsanschluss 8 zur Bereitstellung einer in die Wechselspannung zu wandelnden Gleichspannung von einer Hochvoltbatterie integriert.

Die in Fig. 1 offene Seite des Aufnahmebereichs 5 wird in einem montierten Zustand zusätzlich durch eine Stromrichtereinrichtung 9 (vgl. Figuren 2 bis 5) begrenzt, die auf das Maschinengehäuse 2 aufgesetzt und an den Wänden 4 befestigt wird. Die Stromrichtereinrichtung 9 wandelt die über den Gleichspannungsanschluss 8 bereitgestellte Gleichspannung in die dreiphasige Wechselspannung und erlaubt eine Verbindung der Niedervoltbatterie mit der Anschlussvorrichtung 7. Die Stromrichtereinrichtung 9 weist ferner eine Kühlvorrichtung 10 mit Kühlflüssigkeitsanschlüssen 11 (vgl. Figuren 2 bis 5) auf, die mit der Kühlflüssigkeitsschnittstelle 6 zur Ausbildung eines gemeinsamen Kühlkreislaufs für die elektrische Maschine 1 und die Stromrichtereinrichtung 9 verbunden bzw. verbindbar sind.

Fig. 2 zeigt eine Schnittdarstellung eines ersten Ausführungsbeispiels einer Stromrichtereinrichtung 9, einschließlich des Aufnahmebereichs 5 und des Abschnitts 3 mit den Wänden 4 des Maschinengehäuses 2.

Die Stromrichtereinrichtung 9 umfasst eine Grundplatte 12, in die die Kühlvorrichtung 10 integriert ist, ein erstes Gehäuseteil 13 auf der der elektrischen Maschine 1 zugewandten Seite der Grundplatte 12 und ein zweites Gehäuseteil 14 auf der der elektrischen Maschine 1 abgewandten Seite der Grundplatte 12. Die Kühlvorrichtung 10 durchdringt dabei die Grundplatte 12 und den ersten Gehäuseteil 13 derart, dass sich die Kühlflüssigkeitsanschlüsse 11 (in Fig. 2 nur einer sichtbar) in den Aufnahmebereich 5 erstrecken und dort mit der Kühlflüssigkeitsschnittelle 6 verbindbar sind.

Auf der der elektrischen Maschine 1 abgewandten Seite der Grundplatte 12 sind mehrere Komponenten der Stromrichtereinrichtung 9 angeordnet und vom zweiten Gehäuseteil 14 eingehaust, welches bevorzugt aus einem Metall, beispielsweise Aluminium, ausgebildet ist. Die Komponenten sind eine leistungselektronische Stromrichtereinheit 15, ein Zwischenkreiskondensator 16, Steuereinheiten einer Steuereinrichtung 17 zur Ansteuerung der Stromrichtereinheit 15 sowie ein nicht gezeigter Gleichspannungsanschluss zur Verbindung der Stromrichtereinrichtung mit der Niedervoltbatterie. Die Stromrichtereinheit 15 ist dabei unmittelbar auf der kühlflüssigkeitsdurchströmten Kühlvorrichtung 10 angeordnet, da sie den größten Beitrag zur während des Betriebs der Stromrichtereinrichtung 9 erzeugten Wärme leistet. Der Zwischenkreiskondensator 16 ist mit der Grundplatte 12 thermisch leitfähig gekoppelt, um die von ihm während des Betriebs erzeugte Wärme über die Grundplatte zur Kühlvorrichtung 10 abzuführen.

Auf der der elektrischen Maschine 1 zugewandten Seite der Grundplatte 12 sind weitere Komponenten der Stromrichtereinrichtung 9 angeordnet und vom ersten Gehäuseteil 13 eingehaust, welches aus einem Kunststoff, beispielsweise Polyamid, ausgebildet ist. Die Komponenten sind eine elektromagnetische Filtereinheit 18, ein Wechselspannungsanschluss 19 zur elektrischen Verbindung der Stromrichtereinrichtung 9 mit der Anschlussvorrichtung 7, ein nicht gezeigter Gleichspannungsanschluss zur elektrischen Verbindung der Stromrichtereinrichtung 9 mit einer Hochvoltbatterie über den Gleichspannungsanschluss 8 und ein nicht gezeigter Gleichspannungsanschluss zur elektrischen Verbindung der elektrischen Maschine 1 mit der Niedervoltbatterie über die Anschlussvorrichtung 7.

Während der erste Gehäuseteil 13 auf der Grundplatte 12 aufliegt und an dieser befestigt ist, übergreift der zweite Gehäuseteil 14 die Grundplatte 12 und liegt im montierten Zustand auf dem Abschnitt 3 des Maschinengehäuses 2 auf. Dadurch ist der Aufnahmebereich 5 abgeschlossen. Durch nicht gezeigte Befestigungsmittel ist der zweite Gehäuseteil 14 mit an den Wänden 4 befestigt. Alternativ zu der gezeigten mehrteiligen Ausführung der Gehäuseteile 13, 14 ist es auch denkbar, dass die Gehäuseteile 13, 14 ein zusammenhängendes Gehäuse bilden.

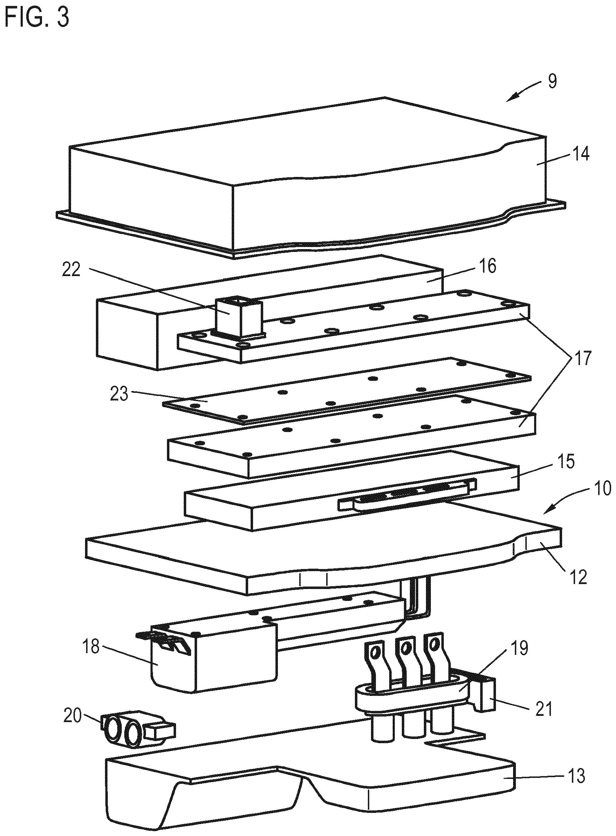

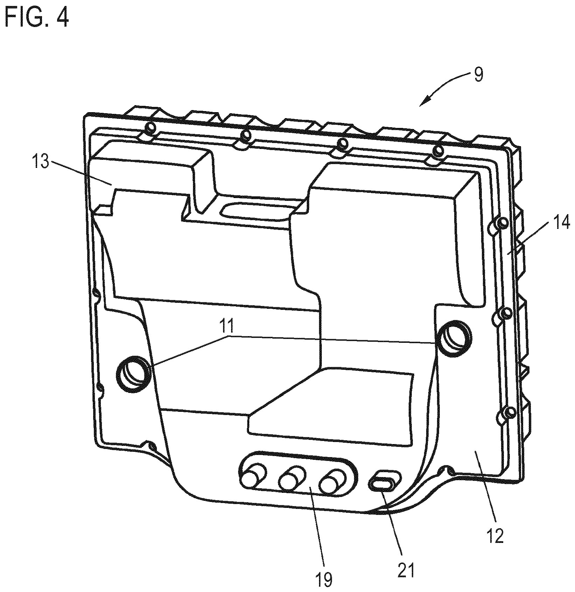

Fig. 3 zeigt eine Explosionsdarstellung eines weiteren Ausführungsbeispiels einer Stromrichtereinrichtung 9, wobei bezüglich Fig. 2 gleiche oder gleichwirkende Elemente mit identischen Bezugszeichen versehen sind. Die Stromrichtereinrichtung 9 unterscheidet sich von der in Fig. 2 Gezeigten im Wesentlichen dadurch, dass die Grundplatte 12 als kühlflüssigkeitsdurchströmte Kühlvorrichtung 10 ausgebildet ist, wozu innerhalb der Grundplatte 12 nicht gezeigte Kühlkanäle vorgesehen sind. Ferner durchdringen die Kühlflüssigkeitsanschlüsse 11 (vgl. Fig. 4) nicht die Grundplatte 12 und den ersten Gehäuseteil 13, sondern sind außerhalb der Gehäuseteile 13, 14 an der der elektrischen Maschine 1 zugewandten Seite der Grundplatte 12 ausgebildet.

In Fig. 3 sind ferner der Gleichspannungsanschluss 20 zur elektrischen Verbindung der Stromrichtereinrichtung 9 mit einer Hochvoltbatterie über den Gleichspannungsanschluss 8, der Gleichspannungsanschluss 21 zur elektrischen Verbindung der elektrischen Maschine 1 mit der Niedervoltbatterie über die Anschlussvorrichtung 7, der Gleichspannungsanschluss 22 zur Verbindung der Stromrichtereinrichtung 9 mit der Niedervoltbatterie und ein Abschirmmittel 23 der Steuereinrichtung 17 zwischen ihren Steuereinheiten gezeigt.

Fig. 4 zeigt eine perspektivische Darstellung der in Fig. 3 gezeigten Stromrichtereinrichtung 9 mit Blick auf die der elektrischen Maschine 1 zugewandte Seite der Grundplatte 12. Ersichtlich sind die Kühlflüssigkeitsanschlüsse 11 der Kühlvorrichtung 10 als Ausnehmungen der Grundplatte 12 ausgebildet, in die die Kühlkanäle münden. Die Kühlflüssigkeitsanschlüsse können so mittels geeigneter Verbindungsmittel mit der Kühlflüssigkeitsschnittstelle 6 der elektrischen Maschine 1 verbunden werden.

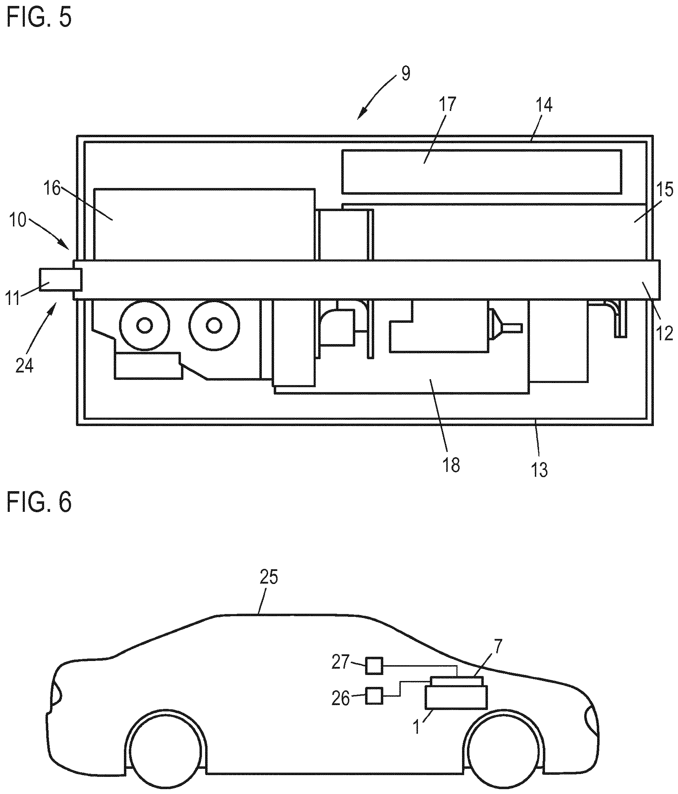

Fig. 5 eine geschnittene Prinzipdarstellung eines weiteren Ausführungsbeispiels einer Stromrichtereinrichtung 9, wobei bezüglich Fig. 3 gleiche oder gleichwirkende Elemente mit identischen Bezugszeichen versehen sind. Die Stromrichtereinrichtung 9 unterscheidet sich von der in Fig. 3 Gezeigten im Wesentlichen dadurch, dass die Kühlflüssigkeitsanschlüsse 11 an einer Randfläche 24 der Grundplatte angeordnet sind.

Fig. 6 zeigt eine Prinzipdarstellung eines Kraftfahrzeugs 25, umfassend eine elektrische Maschine 1 gemäß Fig. 1 zum teilweisen oder vollständigen Antrieb des Kraftfahrzeugs 25 und eine daran befestigte Stromrichtereinrichtung 9 gemäß einem der zuvor genannten Ausführungsbeispiele. Die Stromrichtereinrichtung 9 ist über den Gleichspannungsanschluss 8 mit einem Hochvoltbordnetz 26 und über den Gleichspannungsanschluss 21 mit einem Niedervoltbordnetz 27 des Kraftfahrzeugs 25 verbunden.

## Patentansprüche

1. Kraftfahrzeug, umfassend eine elektrische Maschine (1) zum Antrieb des Kraftfahrzeugs (25) und eine eine Kühlvorrichtung (10) aufweisende Stromrichtereinrichtung (9) zur Bereitstellung eines Wechselstroms für die elektrische Maschine (1), wobei die Kühlvorrichtung (10) wenigstens einen Kühlflüssigkeitsanschluss (11) aufweist, welcher zur Ausbildung eines gemeinsamen Kühlkreislaufs mit einer Kühlflüssigkeitsschnittstelle (6) der elektrischen Maschine (1) flüssigkeitsleitend verbunden ist, wobei die Stromrichtereinrichtung (9) an einem Maschinengehäuse (2) der elektrischen Maschine (1) angeordnet ist,
**dadurch gekennzeichnet,**
**dass** die Stromrichtereinrichtung (9) und ein muldenartiger Abschnitt (3) des Maschinengehäuses (2) einen Aufnahmebereich (5) begrenzen, in welchem der Kühlflüssigkeitsanschluss (11) und die Kühlflüssigkeitsschnittstelle (6) angeordnet sind und der sich in Radialrichtung bezüglich der Rotationsachse der elektrischen Maschine (1) erstreckende Wände (4) aufweist, auf deren freien Enden die Stromrichtereinrichtung (9) aufgesetzt ist, wobei die Stromrichtereinrichtung (9) eine Grundplatte (12) aufweist, an der beidseitig Komponenten der Stromrichtereinrichtung (9) angeordnet sind und ein aus einem Kunststoff ausgebildetes Gehäuseteil (13) der Strom richtereinrichtung (9) die an der der elektrischen Maschine (1) zugewandten Seite angeordneten Komponenten einhaust.

2. Kraftfahrzeug nach Anspruch 1,
**dadurch gekennzeichnet,**
**dass** die Kühlvorrichtung (10) durch mehrere innerhalb der Grundplatte (12) vorgesehene Kühlkanäle ausgebildet ist oder an der Grundplatte (12) angeordnet, insbesondere in diese eingelassen, ist.

3. Kraftfahrzeug nach Anspruch 1 oder 2,
**dadurch gekennzeichnet,**
**dass** der Kühlflüssigkeitsanschluss (11) an der der elektrischen Maschine (1) zugewandten Seite oder an wenigstens einer Randseite (24) der Grundplatte (12) angeordnet ist.

4. Kraftfahrzeug nach einem der vorangehenden Ansprüche,
**dadurch gekennzeichnet,**
**dass** als Komponenten eine leistungselektronische Stromrichtereinheit (15) und/oder ein Zwischenkreiskondensator (16) und/oder eine Steuereinrichtung (17) und/oder ein Gleichspannungsanschluss (22) zur Verbindung der Stromrichtereinrichtung (9) mit einem Niedervoltbordnetz (27) des Kraftfahrzeugs (25) vorgesehen sind.

5. Kraftfahrzeug nach den Ansprüchen 2 und 4,
**dadurch gekennzeichnet,**
**dass** die Stromrichtereinheit (9) auf der an der Grundplatte (12) angeordneten Kühlvorrichtung (10) angeordnet ist.

6. Kraftfahrzeug nach einem der vorangehenden Ansprüche,
**dadurch gekennzeichnet,**
**dass** als Komponenten eine elektromagnetische Filtereinheit (18) und/oder ein Wechselspannungsanschluss (19) zur elektrischen Verbindung der Stromrichtereinrichtung (9) mit der elektrischen Maschine (1) und/oder ein Gleichspannungsanschluss (20) zur elektrischen Verbindung der Stromrichtereinrichtung (9) mit einer Hochvoltanordnung (26) und/oder ein Gleichspannungsanschluss (21) zur elektrischen Verbindung der elektrischen Maschine (1) mit einem Niedervoltbordnetz (27) des Kraftfahrzeugs (25) über die Stromrichtereinrichtung (9) vorgesehen sind.

7. Kraftfahrzeug nach einem der vorangehenden Ansprüche,
**dadurch gekennzeichnet,**
**dass** der Kühlwasseranschluss (11) den Gehäuseteil (13) durchdringt oder außerhalb des Gehäuseteils (13) an der Grundplatte (12) angeordnet ist.

8. Kraftfahrzeug nach Anspruch 7,
**dadurch gekennzeichnet,**
**dass** der außerhalb des Gehäuseteils (13) vorgesehene Kühlwasseranschluss (11) an der der elektrischen Maschine (1) zugewandten Seite der Grundplatte (12) oder an der oder einer Randseite (24) der Grundplatte (12) angeordnet ist.

9. Kraftfahrzeug nach einem der vorangehenden Ansprüche,
**dadurch gekennzeichnet,**
**dass** ein Gehäuseteil (14) der Stromrichtereinrichtung (9) die auf der der elektrischen Maschine abgewandten Seite angeordneten Komponenten einhaust.

10. Kraftfahrzeug nach einem der vorangehenden Ansprüche,
**dadurch gekennzeichnet, dass** die Steuereinrichtung (17) ein Abschirmmittel (23) zwischen ihren Steuereinheiten aufweist.

## Claims

1. Motor vehicle comprising an electric motor (1) for driving the motor vehicle (25) and a power converter apparatus (9) for providing an alternating current for the electric motor (1), the power converter device having a cooling device (10), wherein the cooling device (10) has at least one coolant connection (11) which is connected in a fluid-conducting manner to a coolant interface (6) of the electric motor (1) in order to form a common cooling circuit, wherein the power converter apparatus (9) is arranged on a machine housing (2) of the electric motor (1),
**characterised in that**
the power converter apparatus (9) and a trough-like section (3) of the machine housing (2) delimit a receiving area (5) in which the coolant connection (11) and the coolant interface (6) are arranged and which has walls (4) extending in the radial direction with respect to the axis of rotation of the electric motor (1), on the free ends of which walls the power converter apparatus (9) is mounted, wherein the power converter apparatus (9) has a base plate (12) on both sides of which components of the power converter apparatus (9) are arranged and a plastic housing part (13) of the power converter apparatus (9) houses the components arranged on the side that faces the electric motor (1).

2. Motor vehicle according to claim 1,
**characterised in that**
the cooling device (10) is formed by a plurality of cooling channels provided within the base plate (12), or is arranged on the base plate (12), in particular recessed into the same.

3. Motor vehicle according to claim 1 or 2,
**characterised in that**
the coolant connection (11) is arranged on at least one lateral edge (24) of the base plate (12) or on the side that faces the electric motor (1).

4. Motor vehicle according to any of the preceding claims,
**characterised in that**
a power electronics converter unit (15) and/or a DC link capacitor (16) and/or a control apparatus (17) and/or a DC voltage terminal (22) for connecting the power converter apparatus (9) to a low-voltage electrical system (27) of the motor vehicle (25) are provided as components.

5. Motor vehicle according to claims 2 and 4,
**characterised in that**
the power converter unit (9) is arranged on the cooling device (10), which is arranged on the base plate (12).

6. Motor vehicle according to any of the preceding claims,
**characterised in that**
an electromagnetic filter unit (18) and/or an AC voltage terminal (19) for electrically connecting the power converter apparatus (9) to the electric motor (1) and/or a DC voltage terminal (20) for electrically connecting the power converter apparatus (9) to a high-voltage assembly (26) and/or a DC voltage terminal (21) for electrically connecting the electric motor (1) to a low-voltage electrical system (27) of the motor vehicle (25) via the power converter apparatus (9) are provided as components.

7. Motor vehicle according to any of the preceding claims,
**characterised in that**
the cooling water connection (11) extends through the housing part (13) or is arranged outside the housing part (13) on the base plate (12).

8. Motor vehicle according to claim 7,
**characterised in that**
the cooling water connection (11) provided outside the housing part (13) is arranged on the side of the base plate (12) that faces the electric motor (1) or on the or one lateral edge (24) of the base plate (12).

9. Motor vehicle according to any of the preceding claims,
**characterised in that**
a housing part (14) of the power converter apparatus (9) houses the components arranged on the side that faces away from the electric motor.

10. Motor vehicle according to any of the preceding claims,
**characterised in that** the control apparatus (17) has a shielding means (23) between its control units.

## Revendications

1. Véhicule à moteur, comprenant un moteur électrique (1) pour l'entraînement du véhicule à moteur (25) et un appareil convertisseur de courant (9) présentant un dispositif de refroidissement (10) pour la mise à disposition d'un courant alternatif pour le moteur électrique (1), dans lequel le dispositif de refroidissement (10) présente au moins un raccordement de fluide de refroidissement (11) qui est relié en communication fluidique à une interface de fluide de refroidissement (6) du moteur électrique (1) pour former un circuit de refroidissement commun, dans lequel l'appareil convertisseur de courant (9) est disposé au niveau d'un carter de machine (2) du moteur électrique (1),
**caractérisé en ce que**
l'appareil convertisseur de courant (9) et une section en creux (3) du carter de machine (2) délimitent une zone de réception (5) dans laquelle le raccordement de fluide de refroidissement (11) et l'interface de fluide de refroidissement (6) sont disposées et qui présente des parois (4) s'étendant dans la direction radiale par rapport à l'axe de rotation du moteur électrique (1), sur les extrémités libres desquelles est posé l'appareil convertisseur de courant (9), dans lequel l'appareil convertisseur de courant (9) présente une plaque de base (12) au niveau de laquelle sont disposés sur les deux côtés des composants de l'appareil convertisseur de courant (9) et une partie de carter (13) de l'appareil convertisseur de courant (9) réalisée en matière plastique qui accueille les composants disposés au niveau du côté tourné vers le moteur électrique (1).

2. Véhicule à moteur selon la revendication 1,
**caractérisé en ce que**
le dispositif de refroidissement (10) est réalisé par plusieurs canaux de refroidissement prévus à l'intérieur de la plaque de base (12) ou est disposé au niveau de la plaque de base (12), en particulier introduit dans celle-ci.

3. Véhicule à moteur selon la revendication 1 ou 2,
**caractérisé en ce que**
le raccordement de fluide de refroidissement (11) est disposé au niveau du côté tourné vers le moteur électrique (1) ou au niveau d'au moins un côté de bord (24) de la plaque de base (12).

4. Véhicule à moteur selon l'une quelconque des revendications précédentes,
**caractérisé en ce que**
en tant que composants une unité convertisseuse de courant à électronique de puissance (15) et/ou un condensateur de circuit intermédiaire (16) et/ou un appareil de commande (17) et/ou une borne de tension continue (16) et/ou un système de commande (17) et/ou une borne à tension continue (22) sont prévus pour la connexion de l'appareil convertisseur de courant (9) à un réseau de bord basse tension (27) du véhicule à moteur (25).

5. Véhicule à moteur selon les revendications 2 et 4,
**caractérisé en ce que**
l'unité convertisseuse de courant (9) est disposée sur le dispositif de refroidissement (10) disposé au niveau de la plaque de base (12).

6. Véhicule à moteur selon l'une quelconque des revendications précédentes,
**caractérisé en ce que**
en tant que composants, une unité filtrante électromagnétique (18) et/ou une borne de tension alternative (19) pour une connexion électrique de l'appareil convertisseur de courant (9) au moteur électrique (1) et/ou une borne de tension continue (20) pour une connexion électrique de l'appareil convertisseur de courant (9) à un agencement haute tension (26) et/ou une borne de tension continue (21) pour une connexion électrique du moteur électrique (1) à un réseau de bord basse tension (27) du véhicule à moteur (25) sont prévues via l'appareil convertisseur de courant (9).

7. Véhicule à moteur selon l'une quelconque des revendications précédentes,
**caractérisé en ce que**
le raccordement d'eau froide (11) pénètre dans la partie de carter (13) ou est disposé à l'extérieur de la partie de carter (13) au niveau de la plaque de base (12).

8. Véhicule à moteur selon la revendication 7,
**caractérisé en ce que**
le raccordement d'eau froide (11) prévu à l'extérieur de la partie de carter (13) est disposé au niveau du côté de la plaque de base (12) tourné vers le moteur électrique (1) ou au niveau du ou d'un côté de bord (24) de la plaque de base (12).

9. Véhicule à moteur selon l'une quelconque des revendications précédentes,
**caractérisé en ce que**
une partie de carter (14) de l'appareil convertisseur de courant (9) accueille les composants agencés sur le côté opposé au moteur électrique.

10. Véhicule à moteur selon l'une quelconque des revendications précédentes,
**caractérisé en ce que** l'appareil de commande (17) présente un moyen de protection (23) entre ses unités de commande.
